# FASCICULE DE BREVET EUROPEEN

(11) **EP 1 916 762 B1**
(45) Date de publication et mention de la délivrance du brevet: **30.05.2018**
(21) Numéro de dépôt: 06123107.2
(22) Date de dépôt: 27.10.2006
(51) Int. Cl.: H03B 5/36, H03B 5/04

(54) **Oscillateur à quartz asservi en amplitude avec domaine étendu de tension et de température**
Quarzoszillator mit Amplitudenregelung und einem erweiterten Temperaturbereich
Quartz oscillator with amplitude control and an extended temperature range.

(43) Date de publication de la demande: 30.04.2008
(73) Titulaire: EM Microelectronic-Marin SA, 2074 Marin (CH)
(72) Inventeur: Novac, Pinchas, 2000 Neuchâtel (CH)
(74) Mandataire: Goulette, Ludivine

(56) Documents cités:
- WO-A-03/017284
- JP-A- 11 186 849
- US-A1- 2002 180 542
- US-A1- 2005 174 183

## Description

### DOMAINE TECHNIQUE

La présente invention concerne, de manière générale, un circuit oscillateur destiné à être utilisé pour réaliser une base de temps pour une montre électronique, un téléphone portable ou tout autre dispositif électronique nécessitant une telle base de temps. La présente invention concerne, plus particulièrement, un circuit oscillateur asservi en amplitude.

### ARRIERE-PLAN TECHNOLOGIQUE

Il est connu dans l'art antérieur, en particulier du document CH 580 358, un oscillateur à quartz asservi en amplitude, représenté de manière simplifiée à la figure 6. De tels oscillateurs asservis en amplitude sont utilisés car ils permettent de réduire le courant d'alimentation dès que l'amplitude de l'oscillateur atteint une valeur raisonnable. Le coeur de l'oscillateur consiste en un amplificateur inverseur avec le cristal de quartz comme rétroaction et des capacités de charge C1 et C2 pour fournir le déphasage nécessaire. La transconductance nécessaire pour l'étage d'amplification, et par là même la consommation de courant de l'oscillateur, est pour une fréquence donnée proportionnelle à la résistance série du cristal, de l'amplitude de l'oscillateur et d'un facteur capacitif fonction de la charge déterminée par C1 en série avec C2. Le coeur de l'oscillateur correspondant à l'étage de gain est constitué d'un seul transistor actif N1. La charge est une source de courant I₀ qui est contrôlée par le régulateur d'amplitude. La résistance de rétroaction Rf qui est nécessaire pour la polarisation de la grille du transistor actif N1 doit être très élevée, pour ne pas charger le circuit résonateur. Le transistor complémentaire P1 agit comme source de courant de polarisation du transistor actif N1, par le biais du miroir de courant qu'il forme avec le transistor P2. Cet étage de gain permet une commande aisée de l'amplitude et nécessite une faible tension d'alimentation. Toutefois pour assurer une transconductance optimum choisie, il est nécessaire d'avoir un courant d'alimentation deux fois plus élevée qu'une solution qui consisterait à avoir deux transistors actifs décrits dans le cadre du document CH 623 450 comme représentée à la figure 7.

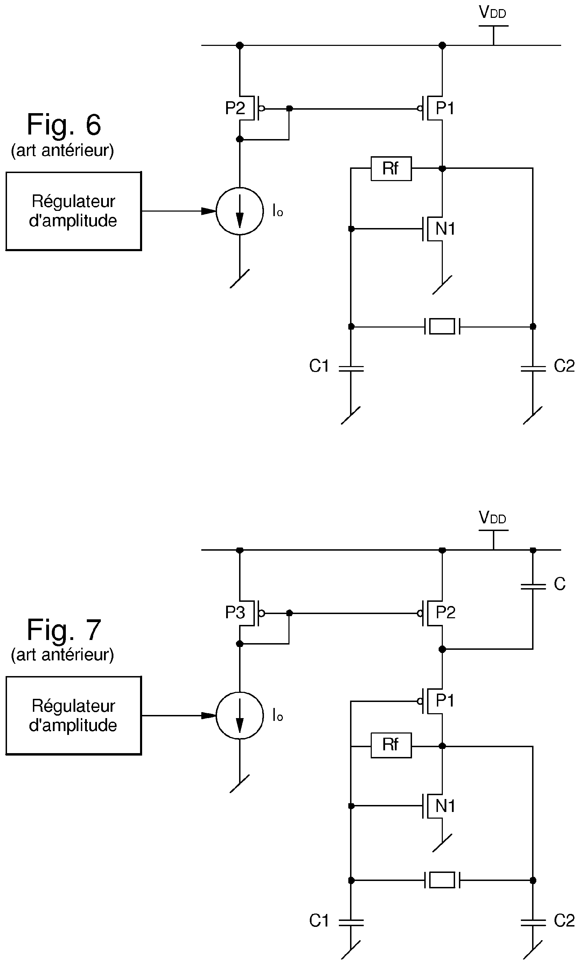

Dans l'exemple de l'art antérieur représenté à la figure 7, l'étage de gain est constitué par deux transistors actifs, un transistor N1 en série avec un transistor complémentaire P1. Les transconductances dans ce cas s'additionnent. Dans la mesure où le même courant continu traverse les deux transistors, la moitié de courant est nécessaire pour obtenir la même transconductance qu'avec une charge de source de courant. Néanmoins, cette solution requiert une tension d'alimentation nettement supérieure ainsi que l'utilisation d'une capacité élevée C en parallèle avec le transistor P2 qui alimente les deux transistors actifs, ce qui occupe une surface importante sur le circuit, en augmente le coût tout en dégradant fortement le taux de réjection de l'alimentation. Le document US 2002/0180542 A1 décrit un oscillateur à quartz avec des moyens de polarisation et des moyens de commande en courant des moyens de polarisation, configuré pour polariser l'oscillateur différemment pendant le démarrage et pendant l'oscillation stable.

Le document US 2005/0174183 A1 décrit un oscillateur à quartz qui est polarisé par un circuit de miroir de courant.

### RESUME DE L'INVENTION

L'un des buts principaux de la présente invention est de pallier aux inconvénients susmentionnés en réalisant un oscillateur ayant une transconductance élevée sans nécessiter l'introduction d'élément dégradant le taux de rejection de l'alimentation.

Pour cela, la présente invention concerne un oscillateur selon la revendication 1. Cet oscillateur permet bien d'obtenir une transconductance élevée grâce à l'utilisation de deux transistors complémentaires polarisés en régime actifs tout en ne dégradant pas le taux de réjection de l'alimentation grâce à l'utilisation de moyens de polarisation du deuxième transistor actif intégrés, ce qui assure en outre une surface nécessaire plus réduite.

Dans la mesure où ce type d'oscillateur est agencé dans de nombreux dispositifs portables pouvant être alimentés de diverses manières et pouvant subir toutes sortes de contraintes, en particulier en température, il est également important d'assurer une gamme étendue de fonctionnement en tension et en température de ce type d'oscillateur. Dans ce but il est notamment prévu en outre une source de courant indépendante et stable en tension comprenant des moyens de protection contre les surtensions dues à une tension d'alimentation trop élevée.

Le but du circuit global de l'oscillateur étant de fournir en sortie un signal d'horloge à une fréquence donnée, il est prévu à cet effet d'adjoindre un amplificateur pour signaux alternatifs à l'entrée du circuit constituant le coeur de l'oscillateur pour s'affranchir des problèmes de distorsion observés à la sortie. Avantageusement, il est prévu un circuit amplificateur inverseur à la borne d'entrée de l'oscillateur comprenant un inverseur formés de deux transistors de types complémentaires, commandés au moyen de deux amplificateurs inverseur à entrée capacitive intégrés alimentés chacun par la sortie de l'autre amplificateur inverseur à entrée capacitive et une borne d'alimentation, respectivement, l'autre borne d'alimentation pour empêcher une pointe de consommation de courant lors de la commutation de la sortie.

Pour élargir le domaine de fonctionnement de l'oscillateur en température, il est avantageusement prévu un détecteur de température associé à un diviseur capacitif pour adapter la fonction de transfert du régulateur d'amplitude

### BREVE DESCRIPTION DES FIGURES

D'autres caractéristiques et avantages de la présente invention apparaîtront plus clairement à la lecture de la description détaillée qui suit de modes de réalisation de l'invention donnés uniquement à titre d'exemple non limitatif et illustrés par les dessins annexés où :
- la figure 1 est le schéma du coeur de l'oscillateur selon un mode de réalisation préféré de l'invention;
- la figure 2 est le schéma global de l'oscillateur selon l'invention;
- la figure 3 est le schéma de l'étage amplificateur inverseur en sortie de l'oscillateur;
- la figure 4 est le schéma de la source de courant stable en tension et en température;
- la figure 5a représente un premier exemple de réalisation du circuit diviseur capacitif placé en entrée du régulateur d'amplitude;
- la figure 5b représente un deuxième exemple de réalisation du circuit diviseur capacitif placé en entrée du régulateur d'amplitude;
- la figure 5c représente l'évolution de la courbe de courant de l'oscillateur en fonction de la tension de l'oscillateur dépendante de la température;
- les figures 6 et 7, déjà décrites, représentent des schémas de coeurs d'oscillateur selon l'art antérieur.

### DESCRIPTION DETAILLEE DE L'INVENTION

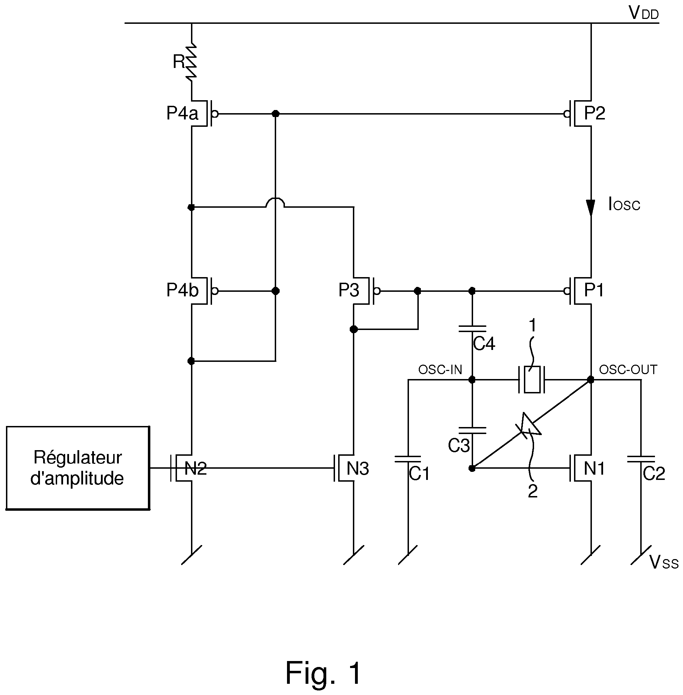

La présente invention qui va maintenant être présentée, est donnée à titre purement illustratif et non limitatif en liaison avec les figures 1 à 5.

La figure 1 représente le coeur d'un oscillateur selon un exemple préféré de réalisation de la présente invention. L'oscillateur comprend une borne d'entrée (osc_in), une borne de sortie (osc_out), un résonateur 1, et un circuit oscillateur, appelé encore coeur de l'oscillateur. Le circuit oscillateur est alimenté par le biais de deux bornes d'alimentation Vss et Vdd. Deux condensateurs C1 et C2 sont branchés entre une des bornes d'alimentation Vss et la borne d'entrée osc_in, respectivement la borne de sortie osc_out de l'oscillateur. Ces condensateurs indispensables peuvent être des éléments branchés comme indiqué ou encore être constitués par des capacités parasites, en particulier celle du transistor actif N1 et des connexions, connectées entre la borne d'alimentation Vss et la borne de sortie osc_out. Des moyens de polarisation, avantageusement formés par une diode connectée entre la grille du transistor actif N1 et la borne de sortie osc_out peuvent être prévus pour polariser le transistor actif N1. Un deuxième transistor actif P1, de type complémentaire du transistor actif N1 est agencé avec un trajet de courant branché en série du transistor actif N1. Une source de courant de polarisation, formée par le transistor P2, du même type de conduction que le transistor actif P1, est connectée entre la deuxième borne de l'alimentation Vdd et la source du transistor actif P1. Des condensateurs C3 et C4 sont connectés entre la borne d'entrée osc_in et les grilles. Ces capacités d'entrée de l'oscillateur permettent d'avoir le signal d'oscillation sur les grilles des transistors actifs tout en ayant une polarisation continue indépendante, ce qui réduit la consommation en courant de l'oscillateur sans en affecter les performances.

De manière astucieuse, les moyens de polarisation P3, P4a, et P4b du transistor actif P1 sont agencés pour fournir, pendant le régime établi de l'oscillateur, une tension de polarisation sur la grille du transistor actif P1 similaire à la tension de grille du transistor P2 à une tension de décalage près. Selon un mode de réalisation avantageux ces moyens de polarisation comprennent trois transistors du même type que le transistor actif P1, un premier transistor P3 assurant, sur la grille du transistor actif P1, la tension de polarisation et des deuxième et troisième transistors P4a et P4b dont les trajets de courant sont branchés en série, et formant un miroir de courant avec le transistor P2. Ces moyens de polarisation sont commandés en courant par le biais de la résistance R et des transistors N2 et N3 connectés entre la borne d'alimentation Vss et le drain du transistor P4b respectivement du transistor P3. Les transistors N2 et N3 sont eux-mêmes reliés par leur grille à un circuit de régulation d'amplitude 4 traditionnel dont la commande de sortie est fonction de l'amplitude du signal d'oscillation de l'oscillateur. On notera encore que pendant la période de démarrage de l'oscillateur les moyens de polarisation P3, P4a et P4b), le transistor P2 et le transistor actif P1 forment un miroir de courant, ce qui permet d'assurer le courant de démarrage de l'oscillateur. Les moyens de polarisation du transistor actif P2 ainsi réalisés, permettent de s'affranchir de l'utilisation d'une résistance élevée pour la polarisation tout en ne dégradant pas le taux de réjection de l'alimentation.

On notera que dans l'exemple donné en liaison avec la figure 1, il est fait référence à un premier transistor actif de conductivité N et un deuxième transistor actif de conductivité complémentaire P. Il est bien évident que le type de conductivité de ces deux transistors peut être inversé, ce qui entraîne une inversion de l'ensemble du circuit oscillateur, inversion dont la réalisation ne pose aucune difficulté pour l'homme du métier et dont nous ne donnerons donc pas le détail ici.

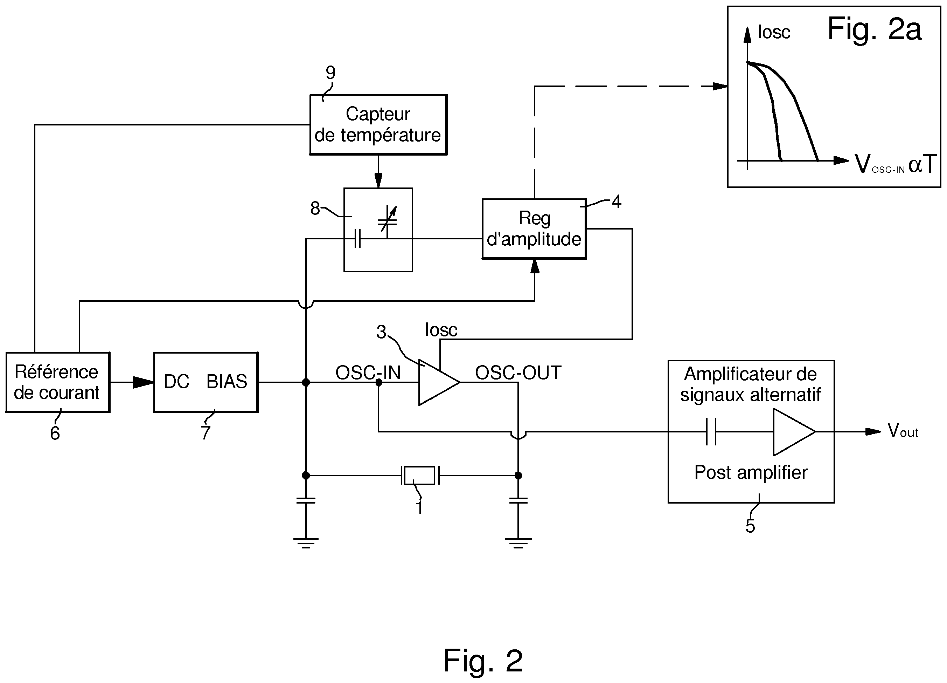

La figure 2 représente un schéma global de l'oscillateur de sorte à étendre le domaine de fonctionnement de ce dernier en tension et en température. On retrouve le résonateur 1 et les capacités C1 et C2 indispensables de l'oscillateur, le coeur de l'oscillateur 3, représenté en détail à la figure 1, le régulateur d'amplitude 4 permettant de commander le courant de l'oscillateur losc en fonction de l'amplitude à l'entrée du coeur de l'oscillateur 3. Le schéma d'un tel régulateur d'amplitude est classique, un exemple est notamment fourni dans un article paru dans le "IEEE Journal of Solid-States Circuits, vol. SC-12, No. 3" daté de juin 1977 et intitulé "CMOS Analog Integrated Circuits Based on Weak Inversion Operation" à la figure 10 de ce document. Le schéma fourni utilise un type de conductivité, il est néanmoins évident qu'un schéma équivalent utilisant le type de conductivité complémentaire peut être également utilisé suivant les besoins du circuit global.

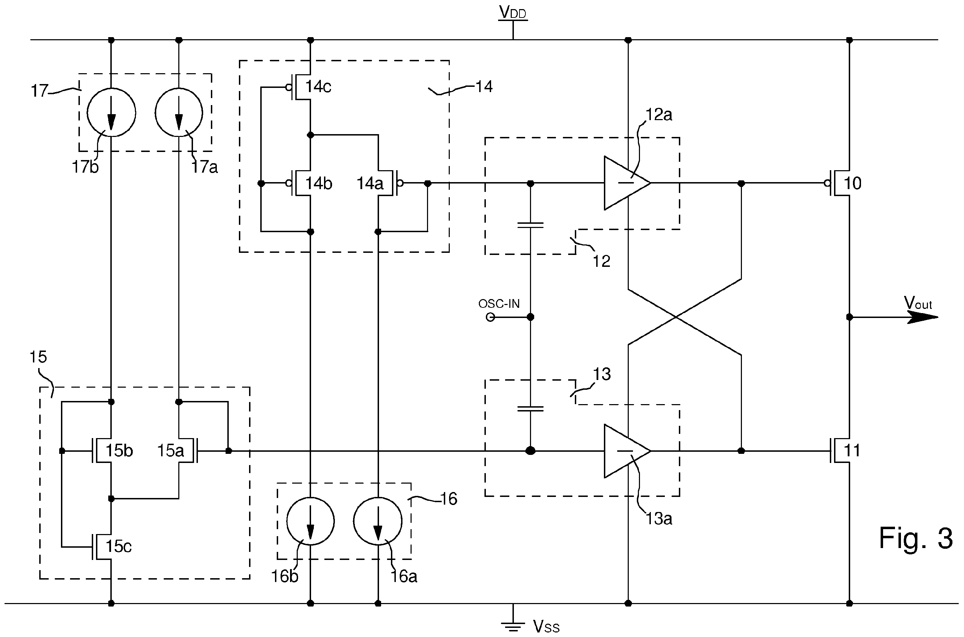

Le but de ce circuit global de l'oscillateur est de fournir en sortie Vout un signal d'horloge à une fréquence donnée, par exemple 32 KHz. A cet effet, il est prévu d'adjoindre un amplificateur pour signaux alternatifs 5 placé à la borne d'entrée osc_in du coeur de l'oscillateur pour s'affranchir des problèmes de distorsion observés à la sortie osc_out. Le détail de cet amplificateur pour signaux alternatifs 5 sera donné en liaison avec la figure 3.

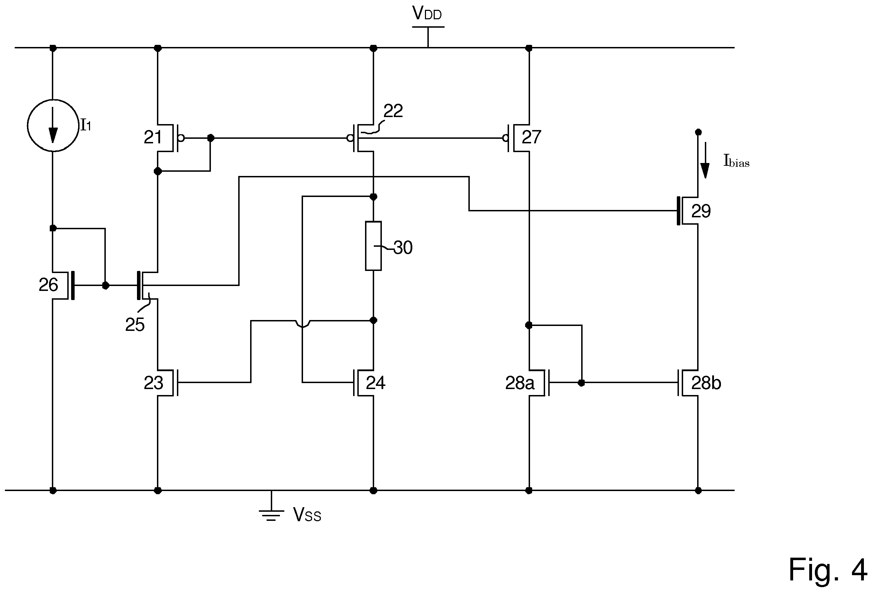

Un objectif de la présente invention est de pouvoir étendre le domaine de fonctionnement de cet oscillateur en tension et en température. Un problème récurrent avec les transistors de technologie MOS utilisés pour réaliser un tel circuit vient des tensions maximales de grille et de drain tolérées en régime saturé qui sont limitées par rapport à la technologie utilisée, et sont par exemple de l'ordre de 3,6 Volts. Cependant, dans de nombreuses applications, il est utile de pouvoir utiliser un tel circuit oscillateur avec une alimentation délivrant une tension d'alimentation plus élevée, par exemple de l'ordre de 5,5 Volts. Afin de pouvoir étendre le domaine de fonctionnement en tension, par exemple de 3,6 Volts à 5,5 Volts, il est prévu d'utiliser une référence de courant stable en température 6 couplée à un circuit de distribution de polarisation dont le détail sera donné en liaison avec la figure 4. Cette référence de courant est de préférence couplée à un circuit de polarisation d'une tension continue 7 qui fixe le niveau de la composante continue à l'entrée osc_in de l'oscillateur.

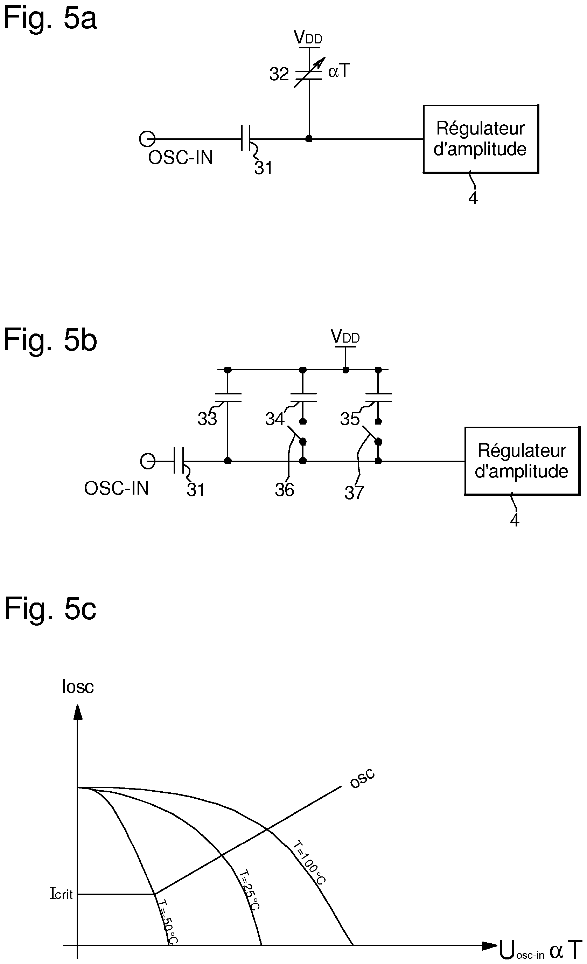

Il est apparu que la limite de fonctionnement de l'oscillateur sur le domaine de température était limitée notamment en raison du régulateur d'amplitude 4. C'est pourquoi afin d'étendre le domaine de fonctionnement en température, il est prévu d'adapter la fonction de transfert du régulateur d'amplitude 4 au moyen d'un diviseur capacitif 8 placé en entrée du régulateur d'amplitude et dont la valeur de capacité dépend de la température détectée au moyen d'un capteur de température 9. Un exemple de diviseur capacitif 8 adaptant la fonction de transfert (voir figure 2a dans l'encadré) du régulateur d'amplitude 4 en fonction de la température détectée est fourni en liaison avec les figures 5a à 5c.

La figure 3 représente l'étage d'amplification pour signaux alternatifs connecté à la borne d'entrée osc_in de l'oscillateur et fournissant le signal de sortie Vout utilisable par le dispositif électronique portable dans lequel l'oscillateur est intégré. On notera que cet étage est placé à la borne d'entrée osc_in de manière à ne pas éviter la distorsion apparaissant à la borne de sortie osc_out.

Cet étage d'amplification pour signaux alternatifs comprend un amplificateur inverseur formés de deux transistors complémentaires 10 et 11, assurant la mise en forme du signal de sortie et commandés au moyen de deux amplificateurs inverseurs à entrée capacitive 12 et 13 intégrés, alimentés chacun par la sortie de l'autre amplificateur inverseur à entrée capacitive et une borne d'alimentation, respectivement, l'autre borne d'alimentation. On notera que l'alimentation des transistors 12 et 13 est avantageusement connectée de manière à éviter une conduction simultanée des transistors 10 et 11 pendant la transition du signal de sortie. L'avantage d'une telle commande sans chevauchement des transistors 10 et 11 est d'éviter une augmentation significative de la consommation pour des tensions d'alimentation étendues. En effet, l'utilisation d'un inverseur CMOS classique où la commande de la grille des deux transistors est commune, entraînerait la présence d'un courant de transition dès que la tension d'alimentation dépasse la somme des tensions de seuil des deux transistors et donc augmenterait fortement avec l'augmentation de la tension d'alimentation (par exemple entre 3 et 5,5V), ce qui n'est évidemment pas souhaitable. Une solution consistant à alimenter un tel inverseur avec un régulateur réducteur de tension n'est également pas souhaitable en raison de la complication que cela entraîne de réduire la tension d'alimentation.

Avantageusement, il est en outre prévu de polariser les entrées des amplificateurs inverseurs 12a, 13a par des moyens de polarisation 14, respectivement 15, permettant non seulement de s'affranchir de l'utilisation d'une grande résistance mais aussi d'utiliser directement la tension d'alimentation disponible dans le reste du circuit oscillateur sans nécessité donc de prévoir un circuit régulateur réducteur de tension d'alimentation. Ces moyens de polarisation comprennent trois transistors de même type que le transistor 10, respectivement 11, de l'amplificateur inverseur de sortie, un premier transistor 14a, respectivement 15a assurant la tension de polarisation de l'amplificateur l'inverseur 12a, respectivement 13a, et des deuxième et troisième transistors 14b et 14c, respectivement 15b et 15c dont les trajets de courant sont branchés en série, le drain du transistor 14a, respectivement 15a étant connecté entre les transistors 14b et 14c, respectivement 15b et 15c. Les transistors 14a et 14b sont reliés à la borne d'alimentation Vss via une source de courant 16a, respectivement 16b. De même les transistors 15a et 15b sont reliés à la borne d'alimentation Vdd une source de courant 17a, respectivement 17b.

La figure 4 représente un mode de réalisation avantageux d'une source de courant stable en tension et en température permettant en particulier d'étendre le domaine de fonctionnement en tension de l'oscillateur. La source de courant comprend deux transistors 21 et 22, par exemple de conductivité P, formant un premier miroir de courant avec un gain déterminé par les caractéristiques des transistors. Elle comprend en outre deux transistors 23 et 24, de conductivité complémentaire N, fonctionnant en régime de faible inversion auxquels on a ajouté une résistance 30 agencée entre les deux grilles des deux transistors 23 et 24.

Pour éviter que les bornes de courant, drain et source, du transistor 23 ne soient soumises à une différence de potentiel trop importante, dans le cas d'une tension d'alimentation de l'ordre de 5 Volts entre les bornes Vdd et Vss, il est prévu d'insérer dans la branche formée par les transistors 21 et 23, un transistor haute tension 25 monté en mode source suiveur pour séparer le drain du transistor 23 de la tension d'alimentation Vdd moins la tension de seuil du transistor 21. Le transistor haute tension 25 est commandé par le biais d'une source de courant I₁ et un autre transistor haute tension 26 monté en miroir de courant avec le transistor haute tension 25. De cette manière, la tension de drain du transistor 23 sera égale à la tension de grille du transistor haute tension 25 égale environ à une tension de seuil moins sa propre tension de seuil.

Afin éviter que les bornes de courant, drain et source, du transistor 22 ne soient soumises à une différence de potentiel trop importante, bien que cela soit moins critique que pour le transistor 23, en raison de la chute de potentiel à travers la résistance 30, il est prévu néanmoins d'avoir une protection en utilisant pour le transistor 22, un transistor à canal allongé.

Ainsi, cette source de courant présente l'avantage de fournir une solution avec domaine étendu de tension.

La distribution du courant de polarisation ayant comme référence cette source de courant, au reste du circuit oscillateur est réalisée par une structure en miroirs de courant, par le biais d'un transistor 27 formant miroir de courant avec le transistor 22 associée à un miroir de courant formé par les transistors 28a et 28b. De la même manière que pour le transistor 23, afin de prémunir l'ensemble du circuit de différences de potentiel trop importantes dues à l'utilisation d'une alimentation plus élevée, il est prévu de protéger le(s) transistor(s) 28b par le biais d'un/des transistor(s) haute tension 29 connecté en mode source suiveur et ayant sa grille connectée au même potentiel que celle du transistor haute tension 26. Ceci améliore également le contrôle du courant de polarisation en assurant une même tension de drain pour les transistors des miroirs de courant.

La figure 5a représente un premier exemple de schéma d'un diviseur capacitif agencé entre le capteur de température et le régulateur d'amplitude 4. Ce diviseur capacitif introduit un facteur d'atténuation permettant d'adapter la fonction de transfert du régulateur d'amplitude. Selon cet exemple, le diviseur capacitif comprend un premier condensateur 31 de valeur de capacité déterminée et un deuxième condensateur 32 à capacité variable dont la valeur de capacité dépend de la température détectée. Ainsi la valeur de capacité du condensateur variable 32 est augmentée lorsque la température baisse, de manière à diminuer le facteur d'atténuation résultant du rapport de capacité C31/C32 et inversement la valeur de capacité du condensateur 32 est diminuée lorsque la température augmente, de manière à augmenter le facteur d'atténuation. Il en résulte que la fonction de transfert du régulateur d'amplitude 4 est adaptée de telle sorte que le point de fonctionnement avec l'oscillateur correspond à un courant losc supérieur au courant critique Icrit en dessous duquel l'amplitude décroît fortement.

La figure 5b représente un deuxième exemple de schéma d'un diviseur capacitif réalisé à partir de composants discrets. On retrouve le condensateur 31 ayant une valeur de capacité donnée. Le condensateur à capacité variable 32 est remplacé dans cet exemple par trois condensateurs 33, 34 et 35 branchés en parallèle les uns des autres de manière à ce que leurs capacités s'ajoutent. Des interrupteurs 36 et 37 sont prévus sur les branches contenant les condensateurs 34, respectivement 35, de manière à pouvoir fixer au moins trois facteurs d'atténuation, correspondant à trois plages de température, suivant que ces interrupteurs sont ouverts ou fermés.

Ainsi par exemple, un premier facteur d'atténuation FA=C31/(C33+C34) obtenu lorsque l'interrupteur 36 est fermé et l'interrupteur 37 est ouvert, est utilisé pour une plage de température allant de 0°C à 70°C. Un deuxième facteur d'atténuation FA_BT=C31/(C33+C34+C35) obtenu lorsque les deux interrupteurs 36 et 37 sont fermés, est utilisé pour des basses températures inférieures à 0°C. Un troisième facteur d'atténuation FA_HT=C31/C33 obtenu lorsque les deux interrupteurs 36 et 37 sont ouverts, est utilisé pour des hautes températures supérieures à 70°C.

La figure 5c représente l'évolution de la courbe de courant de l'oscillateur losc en fonction de la tension en entrée de l'oscillateur Uosc_in en fonction du facteur d'atténuation appliqué (FA, FA_BT, FA_HT) dépendant des valeurs de température détectées.

On comprendra que diverses modifications et / ou améliorations et / ou combinaisons évidentes pour l'homme du métier peuvent être apportées aux différents modes de réalisation de l'invention exposés ci-dessus sans sortir du cadre de l'invention défini par les revendications annexées.

## Revendications

1. Oscillateur comprenant une borne d'entrée (osc_in), une borne de sortie (osc_out), un résonateur (1), et un circuit oscillateur comprenant :
- des première et deuxième bornes d'alimentation (Vss, Vdd);
- deux condensateurs (C1, C2) branchés entre la première borne d'alimentation (Vss) et la borne d'entrée (osc_in), respectivement la borne de sortie (osc_out) de l'oscillateur;
- un premier transistor actif (N1) dont le trajet de courant est connecté entre la première borne de l'alimentation (Vss) et la borne de sortie (osc_out),
- des premiers moyens de polarisation (2) du premier transistor actif (N1),
- un deuxième transistor actif (P1), de type complémentaire du premier transistor actif (N1), dont le trajet de courant est branché en série avec le trajet de courant du premier transistor actif (N1), et formant avec ce dernier un amplificateur inverseur connecté entre la borne d'entrée et la borne de sortie,
- des deuxièmes moyens de polarisation (P3, P4a, P4b) du deuxième transistor actif (P1),
- une première source de courant (P2) formée par un transistor, du même type que le deuxième transistor actif (P1), entre la deuxième borne de l'alimentation (Vdd) et le deuxième transistor actif (P1),
- des moyens de commande en courant (R, N2, N3) des deuxièmes moyens de polarisation (P3, P4a, P4b),
l'oscillateur étant tel qu'en période de régime établi, lesdits deuxièmes moyens de polarisation (P3, P4a, P4b) sont agencés pour fournir une tension de polarisation sur la grille du deuxième transistor actif (P1) et la grille du transistor de la première source de courant (P2) reçoit une tension, **caractérisé en ce que** l'oscillateur comporte un circuit amplificateur inverseur (5) à la borne d'entrée de l'oscillateur (osc_in), comprenant un inverseur formé de deux transistors de types complémentaires (10, 11), lesdits transistors (10, 11) étant commandés au moyen d'un premier et d'un second amplificateur inverseur à entrée capacitive (12, 13) dont les entrées capacitives sont couplées à la borne d'entrée de l'oscillateur, le premier amplificateur (12) étant alimenté par la sortie du second amplificateur (13) et la deuxième borne d'alimentation (Vdd), le second amplificateur (13) étant alimenté par la sortie du premier amplificateur (12) et la première borne d'alimentation (Vss).

2. Oscillateur selon la revendication 1, **caractérisé en ce que** lesdits deuxièmes moyens de polarisation (P3, P4a, P4b) comprennent trois transistors du même type que le deuxième transistor actif (P1), un premier transistor (P3) assurant, sur la grille du deuxième transistor actif (P1), la tension de polarisation des deuxième et troisième transistors (P4a, P4b) dont les trajets de courant sont branchés en série et formant un miroir de courant avec le transistor formant la première source de courant (P2).

3. Oscillateur selon la revendication 1 ou 2, **caractérisé en ce qu'**en période démarrage desdits deuxièmes moyens de polarisation (P3, P4a, P4b), ladite première source de courant (P2) et ledit deuxième transistor actif (P1) forment un miroir de courant.

4. Oscillateur selon l'une des revendications 1 à 3, **caractérisé en ce que** lesdits moyens de commande en courant sont formés par deux transistors de commande (N2, N3) dont la grille est connectée à un régulateur d'amplitude (4) et une résistance (R) agencée entre la deuxième borne d'alimentation et le deuxième transistor (P4a) desdits deuxièmes moyens de polarisation.

5. Oscillateur selon l'une des revendications précédentes, **caractérisé en ce que** le circuit amplificateur inverseur comprend des troisième et quatrième moyens de polarisation pour polariser lesdits amplificateurs inverseur à entrée capacitive, lesdits troisième et quatrième moyens de polarisation étant agencés de manière à utiliser directement la tension d'alimentation disponible dans le reste du circuit oscillateur.

## Patentansprüche

1. Oszillator, umfassend einen Eingangsanschluss (osc_in) und einen Ausgangsanschluss (osc_out), einen Resonator (1) und eine Oszillatorschaltung, die ihrerseits umfasst:
- einen ersten und einen zweiten Versorgungsanschluss (Vss, Vdd);
- zwei Kondensatoren (C1, C2), die zwischen den ersten Versorgungsanschluss (Vss) und den Eingangsanschluss (osc_in) und entsprechend den Ausgangsanschluss (osc_out) des Oszillators geschaltet sind;
- einen ersten aktiven Transistor (N1), dessen Strompfad zwischen den ersten Versorgungsanschluss (Vss) und den Ausgangsanschluss (osc_out) geschaltet ist,
- erste Vorspannungsmittel (2) des ersten aktiven Transistors (N1),
- einen zweiten aktiven Transistor (P1) des zu dem ersten aktiven Transistor (N1) komplementären Typs, dessen Strompfad mit dem Strompfad des ersten Transistors (N1) in Reihe geschaltet ist und mit diesem Letzteren einen invertierenden Verstärker bildet, der zwischen den Eingangsanschluss und den Ausgangsanschluss geschaltet ist,
- zweite Vorspannungsmittel (P3, P4a, P4b) des zweiten aktiven Transistors (P1),
- eine erste Stromquelle (P2), die durch einen Transistor desselben Typs wie der zweite aktive Transistor (P1) gebildet ist, zwischen dem zweiten Versorgungsanschluss (Vdd) und dem zweiten aktiven Transistor (P1),
- Stromsteuermittel (R, N2, N3) der zweiten Vorspannungsmittel (P3, P4a, P4b),
wobei der Oszillator so beschaffen ist, dass in einem Zeitraum stationären Betriebs die zweiten Vorspannungsmittel (P3, P4a, P4b) dafür ausgelegt sind, eine Vorspannung an das Gate des zweiten aktiven Transistors (P1) anzulegen, und das Gate des Transistors der ersten Stromquelle (P2) eine Spannung empfängt,
**dadurch gekennzeichnet, dass** der Oszillator eine invertierende Verstärkerschaltung (5) am Eingangsanschluss des Oszillators (osc_in) aufweist, die einen Inverter enthält, der aus zwei Transistoren (10, 11) komplementärer Typen gebildet ist, wobei die Transistoren (10, 11) mittels eines ersten und eines zweiten invertierenden Verstärkers mit kapazitivem Eingang (12, 13) gesteuert werden, deren kapazitive Eingänge mit dem Eingangsanschluss des Oszillators gekoppelt sind, wobei der erste Verstärker (12) durch den Ausgang des zweiten Verstärkers (13) und den zweiten Versorgungsanschluss (Vdd) versorgt wird, wobei der zweite Verstärker (13) durch den Ausgang des ersten Verstärkers (12) und den ersten Versorgungsanschluss (Vss) versorgt wird.

2. Oszillator nach Anspruch 1, **dadurch gekennzeichnet, dass** die zweiten Vorspannungsmittel (P3, P4a, P4b) drei Transistoren desselben Typs wie der zweite aktive Transistor (P1) umfassen, wobei ein erster Transistor (P3) am Gate des zweiten aktiven Transistors (P1) die Vorspannung sicherstellt und die Strompfade des zweiten und des dritten Transistors (P4a, P4b) in Reihe geschaltet sind und mit dem Transistor, der die erste Stromquelle (P2) bildet, einen Stromspiegel bilden.

3. Oszillator nach Anspruch 1 oder 2, **dadurch gekennzeichnet, dass** in einem Anlaufzeitraum die zweiten Vorspannungsmittel (P3, P4a, P4b), die erste Stromquelle (P2) und der zweite aktive Transistor (P1) einen Stromspiegel bilden.

4. Oszillator nach einem der Ansprüche 1 bis 3, **dadurch gekennzeichnet, dass** die Stromsteuermittel durch zwei Steuertransistoren (N2, N3) gebildet sind, deren Gate mit einem Amplitudenregulierer (4) und mit einem Widerstand (R) verbunden ist, der zwischen dem zweiten Versorgungsanschluss und dem zweiten Transistor (P4a) der zweiten Vorspannungsmittel angeordnet ist.

5. Oszillator nach einem der vorhergehenden Ansprüche, **dadurch gekennzeichnet, dass** die invertierende Verstärkerschaltung dritte und vierte Vorspannungsmittel umfasst, um die invertierenden Verstärker mit kapazitivem Eingang vorzuspannen, wobei die dritten und vierten Vorspannungsmittel dafür ausgelegt sind, direkt die Versorgungsspannung zu verwenden, die im Rest der Oszillatorschaltung verfügbar ist.

## Claims

1. Oscillator including an input terminal (osc_in), an output terminal (osc_out), a resonator (1), and an oscillator circuit including:
- first and second power supply terminals (Vss, Vdd),
- two capacitors (C1, C2) connected between the first power supply terminal (Vss) and the input terminal (osc_in), respectively the output terminal (osc_out) of the oscillator,
- a first active transistor (N1) having a current path connected between the first power supply terminal (Vss) and the output terminal (osc_out),
- first means (2) for polarising the first active transistor (N1),
- a second active transistor (P1), of complementary type to the first active transistor (N1) and whose current path is series connected with the first active transistor (N1) and forming therewith an inverting amplifier, connected between the input and the output terminals
- second means (P3, P4a, P4b) for polarising the second active transistor (P1),
- a first current source (P2) formed by a transistor of the same type as the second active transistor (P1), between the second power supply terminal (Vdd) and the second active transistor (P1),
- current control means (R, N2, N3) for the second polarising means (P3, P4a, P4b),
the oscillator being such that in steady operating conditions, said second polarising means (P3, P4a, P4b) are arranged for providing a polarisation voltage on the gate of the second active transistor (P1) and the transistor gate of the first current source (P2) receives a voltage,
**characterized in that** the oscillator comprises an inverting amplifier circuit (5) provided at the oscillator input terminal (osc_in), including an inverter formed of two transistors of complementary types (10, 11), said transistors (10, 11) being controlled by means of a first and a second inverting amplifiers with capacitive inputs (12, 13), said capacitive inputs being coupled with the input terminal of the oscillator, the first amplifier (12) being powered by the output of the second amplifier (13) et the second power supply terminal (Vdd), the second amplifier (13) being powered by the output of the first amplifier (12) and the first power supply terminal (Vss).

2. Oscillator according to claim 1, **characterized in that** said second polarising means (P3, P4a, P4b) include three transistors of the same type as the second active transistor (P1), a first transistor (P3) providing, at the gate of the second active transistor (P1), the polarisation voltage of the second and third transistors (P4a, P4b) whose current paths are series connected and form a current mirror with the transistor forming the first current source (P2).

3. Oscillator according to claim 1 or 2, **characterized in that** in the start up period of said second polarising means (P3, P4a, P4b), said first current source (P2) and said second active transistor (P1) form a current mirror.

4. Oscillator according to any of claims 1 to 3, **characterized in that** said current control means are formed by two control transistors (N2, N3) whose gate is connected to an amplitude regulator (4) and a resistor (R) arranged between the second supply terminal and the second transistor (P4a) of said second polarising means.

5. Oscillator according to claim 5, **characterized in that** the inverting amplifier circuit includes third and fourth polarising means for polarising said capacitive input inverting amplifiers, said third and fourth polarising means being arranged so as to use directly the supply voltage available in the rest of the oscillator circuit.
